# EUROPÄISCHE PATENTSCHRIFT

(11) **EP 4 111 835 B1**
(45) Veröffentlichungstag und Bekanntmachung des Hinweises auf die Patenterteilung: **08.10.2025**
(21) Anmeldenummer: 21708558.8
(22) Anmeldetag: 12.02.2021
(51) Int. Cl.: H05K 5/02, H05K 5/06, H02G 3/22

(54) **KABELEINLASSVORRICHTUNG FÜR EINEN SCHALTSCHRANK SOWIE ANORDNUNG UND VERFAHREN ZUM BETRIEB DERSELBEN**
CABLE INLET DEVICE FOR A SWITCHGEAR CABINET AND ARRANGEMENT AND METHOD FOR OPERATING SAME
DISPOSITIF D'ENTRÉE DE CÂBLE POUR ARMOIRE DE COMMANDE, SON AGENCEMENT ET SON PROCÉDÉ DE FONCTIONNEMENT

(30) Priorität: 26.02.2020 DE 102020104994
(43) Veröffentlichungstag der Anmeldung: 04.01.2023
(73) Patentinhaber: HARTING Electric Stiftung & Co. KG, 32339 Espelkamp (DE)
(72) Erfinder: HACKEMEIER, Florian, 32339 Espelkamp (DE)
(86) Internationale Anmeldenummer: PCT/DE2021/100140
(87) Internationale Veröffentlichungsnummer: WO 2021/170175

(56) Entgegenhaltungen:
- WO-A1-2006/037522
- DE-C1- 4 207 281
- US-A1- 2019 237 901

## Beschreibung

Die Erfindung geht aus von einer Anordnung, aufweisend einen Schaltschrank sowie eine Kabeleinlassvorrichtung nach der Gattung des unabhängigen Anspruchs 1.

Außerdem geht die Erfindung aus von einem Verfahren zum Betrieb der Anordnung nach Anspruch 1.

Derartige Anordnungen und Verfahren werden benötigt, um Kabel in Schaltschränke einzuführen, zugentlastend daran zu befestigen und an ihrem Einführbereich abzudichten.

### Stand der Technik

Im Stand der Technik sind Kabeleinführungen für Schaltschränke beispielsweise aus dem Wikipedia-Artikel https://de.wikipedia.org/wiki/Kabeleinführung bekannt.

Die Druckschrift EP 2 746 634 A1 offenbart einen vergleichbaren Kabelhalter mit einem U-förmigen Rahmen und einer Anzahl von Dichteinsätzen ("Tüllen") zum Hindurchführen von Kabeln. Dieser Kabelhalter besitzt einen U-förmigen Rahmen mit zwei Schenkeln und einen diese beiden Schenkel miteinander verbindenden Steg. Weiterhin besitzt der Kabelhalter eine Anzahl von Dichteinsätzen. Jeder dieser Dichteinsätze weist wenigstens eine Bohrung zum Hindurchführen eines Kabels auf. Der Kabelhalter besitzt weiterhin einen Riegel, der im montierten Zustand die beiden Schenkel miteinander verbindet und auf die kabelbestückten Dichteinsätze einen Druck ausübt. Ausgehend von diesem Stand der Technik schlägt die Druckschrift vor, den Riegel und/oder den Rahmen aus elastischem Material zu bilden, wobei die beiden Enden des Riegels und die freien Enden der Schenkel Rücksprünge oder Vorsprünge aufweisen, welche miteinander eine Schnappverbindung bilden.

Weiterhin ist es im Stand der Technik bekannt, aus dem Bereich der Schwerlaststeckverbinder stammende Anbaugehäuse derart zu modifizieren, dass sie als Kabeleinführung für Schaltschränke geeignet sind.

Die Druckschrift EP 2 845 277 B1 offenbart ein Durchführungsgehäuse für eines oder mehrere Kabel. Dieses besitzt ein Gehäuseunterteil, welches zum Anordnen an ein Schaltschrankgehäuse ausgelegt ist, und weiterhin ein Gehäuseoberteil. Letzteres ist von einem offenen Zustand, in dem es nicht am Gehäuseunterteil festgelegt ist, in einen geschlossenen Zustand, in dem es am Gehäuseunterteil befestigt ist und dieses insbesondere dichtend abdeckt, bringbar. Im Gehäuseunterteil ist wenigstens eine Kabeldurchführungsdichtung zur Aufnahme eines insbesondere vorkonfektionierten Kabels vorgesehen. Zusätzlich umfasst das Durchführungsgehäuse je eine Zugentlastung für das mindestens eine Kabel. Außerdem wird offenbart, auch im Gehäuseoberteil Kabeldurchführungsdichtungen und Zugentlastungen anzuordnen.

Nachteilig bei dieser Bauform ist, dass sich das Dichtverhalten zwischen den beidseitigen Kabeldurchführungsdichtungen und einer zwischen den Gehäuseteilen zu Abdichtung üblichen und notwendigen Ringdichtung aufgrund der sogenannten "T-Form" dieser gesamten Dichtanordnung erfahrungsgemäß deutlich verschlechtert. Außerdem ist bei den Kabeln, die im Gehäuseoberteil gehalten sind, beim Schließen des Oberteils im Schaltschrank eine gewisse Kabellängung zu verzeichnen. Diese Gesamtanordnung ist somit nicht nur technisch nachteilig, sondern zudem vergleichsweise aufwendig und teuer.

Um Verbesserungen in der Bedienung und der Abdichtung zu erreichen schlägt die Druckschrift DE 10 2016 114 577 A1 darauf aufbauend Folgendes vor: An einer Innenseite eines bevorzugt einteiligen Anbaugehäuses sind separate Zugentlastungselemente wie z.B. Kabelschellen oder Kabelbinder angebracht. Diese sind durch ein Montagefenster betätigbar, welches an einer gegenüberliegenden Gehäuseseite vorgesehen ist. Durch Schließen des Fensters mit einem Deckel werden die Dichtungselemente komprimiert und dichten die Kabel gegen das Anbaugehäuse ab.

Nachteilig bei all diesen bekannten Anordnungen ist, dass sie in ihrer Konstruktion und ihrem Einsatz sehr aufwendig sind. Sie weisen eine große Anzahl an teuren Einzelteilen auf und die Installationszeit ist unerwünscht hoch. Im Feld gestaltet sich weiterhin die Austauschbarkeit der Kabel mit den dazugehörigen Dichtelementen aufwändig und schwierig.

Das Deutsche Patent- und Markenamt hat in der Prioritätsanmeldung zu vorliegender Anmeldung den folgenden Stand der Technik recherchiert: EP 0 560 119 A1, DE 42 07 281 C1, ES 2 167 149 A1, DE 10 2016 114 577 A1, EP 2 845 277 B1 und EP 2 746 634 A1.

Die Druckschrift EP 3 517 816 A1 - auch veröffentlicht als US 2019/023790 A1 - offenbart einen vorgeöffneten Dichteinsatz, aufnehmbar in ein Rahmenteil zum Einbau in ein Steckverbindergehäuse, insbesondere ein Steckverbindergehäuse eines Steckverbinders, der ein Modularsystem besitzt.

Die Druckschrift WO 2006/037522 A1 erwähnt als Stand der Technik eine Anordnung mit zwei Blechen, die an einem Rahmen des Schaltschranks befestigt sind und so dessen Boden bilden. Die Bleche weisen Durchbrechungen auf, die zu einer Längsseite der Bleche offen sind. Die Bleche sind so angeordnet, dass die Durchbrechungen paarweise miteinander kommunizieren, wobei zwei Durchbrechungen einen Bodendurchbruch bilden. In jede Durchbrechung ist eine Hälfte eines Halterahmens eingesetzt, in die Tüllen zur Aufnahme von Kabeln einschiebbar sind. Zwei Hälften werden mittels einer Schraubverbindung zu einem Halterahmen zusammengesetzt, der einen Bodendurchbruch vollständig ausfüllt.

Die vorgenannte Druckschrift kritisiert an dieser Bauform, dass ein Austausch einzelner Kabel bzw. Kabeltüllen sehr aufwendig sei. Es müssten nicht nur die Bodenbleche vom Rahmen entfernt werden, sondern, um eine Tülle mit einem Kabel entnehmen zu können, muss der Halterahmen in seine beiden Hälften zerlegt werden.

Zur Verbesserung schlägt die Druckschrift darauf aufbauend eine Kabeleinführungsvorrichtung für eine Gehäusewand, vorzugsweise für den Boden eines Schaltschranks, vor. Diese besitzt einen Rahmen, in den einzelne, aneinandergereihte flächige Wandsegmente eingesetzt sind, welche mit ihren Schmalseiten am Rahmen befestigt sind, wobei zumindest ein erstes Wandsegment mindestens eine zu einer seiner Längsseiten offene Durchbrechung aufweist, an der ein Halterahmen angebracht ist. Der Halterahmen besitzt Rahmenöffnungen, die zu einer Einschubseite des Halterahmens offen sind und in die Tüllen zur Aufnahme von durch die Durchbrechung durchzuführenden Kabeln bündig mit der Außenkontur des Halterahmens an der Einschubseite abschließend einsetzbar sind. Der Halterahmen erstreckt sich mit seiner Einschubseite in der Draufsicht mindestens bis zu einer entlang der Längsseite des ersten Wandsegments, zu der die Durchbrechung offen ist, verlaufenden Begrenzungslinie. Erfindungsgemäß ist vorgesehen, dass ein zweites Wandsegment mit einer seiner Längsseiten in der Draufsicht entlang der Begrenzungslinie an das erste Wandsegment anliegend angeordnet ist.

Die Druckschrift DE 42 07 281 C1 betrifft eine Kabeleinführeinrichtung für einen Schaltschrank mit einer offenen Bodenseite, die von Rahmenschenkeln eines Rahmengestelles umschlossen und mittels einzelner, aneinanderreihbarer Bodenbleche verschliessbar ist. Die einzelnen Bodenbleche sind mit ihren Schmalseiten mit den zugekehrten Rahmenschenkeln des Rahmengestelles verbindbar. Weiterhin sind sie entlang einer Längsseite mit portalartigen Aussparungen zur Aufnahme von Kabeltüllen versehen. Die Kabeltüllen nehmen Kabel auf. So sind Kabel durch Aussparungen der Bodenseite eingeführt. und sind in Schottblechen zur Abdeckung der Aussparungen gehalten. Die Bodenbleche weisen zumindest entlang einer Längsseite einen abgekanteten Rand auf. Die Bodenbleche sind entlang einer Längsseite mit den Aussparungen mit abgekanteten Rändern verbunden. Weiterhin dichten Dichtungsstreifen die aufeinanderstoßenden Längsseiten benachbarter Bodenbleche ab.

### Aufgabenstellung

Die Aufgabe der Erfindung besteht darin, eine einfache und praktisch handhabbare Kabeleinlassvorrichtung für einen Schaltschrank vorzustellen und weiterhin eine Anordnung und ein Verfahren anzugeben, welche die Bestückung eines Schaltschranks vereinfachen. Insbesondere soll das nachträgliche Auswechseln von in den Schaltschrank eingeführten Kabeln erleichtert werden.

Die Aufgabe wird durch den Gegenstand der unabhängigen Ansprüche gelöst.

Vorteilhafte Ausgestaltungen der Erfindung sind in den Unteransprüchen und der folgenden Beschreibung angegeben.

Eine Kabeleinlassvorrichtung für einen Schaltschrank weist ein starres - also z.B. ein aus einem starren Material bestehendes - Rahmenteil, auf. Das Rahmenteil besitzt eine Montagefläche zur Befestigung an einer als Montagewand vorgesehenen Schaltschrankwand im Bereich eines zur Kabeleinführung in den Schaltschrank vorgesehenen Wanddurchbruchs. Bei der Montagewand kann es sich - je nach Aufbau des Schaltschranks und je nach der jeweiligen Anforderung - in jeweils einer für die jeweilige Anwendung sinnvollen und daher vorteilhaften Ausgestaltung um eine Seitenwand oder auch um eine Vorder- und/oder eine Rückwand des Schaltschranks handeln. An seiner Montagefläche besitzt das Rahmenteil eine Montagedichtung zur Abdichtung gegenüber der besagten Montagewand des Schaltschranks. Diese Montagedichtung kann beispielsweise durch eine Dichtfläche, z.B. eine geeignet ausgeschnittene Gummifolie, gebildet sein. Alternativ oder ergänzend kann sie aber auch eine Dichtung besitzen, die in einer Dichtungsnut der Montagefläche gehalten und geführt ist, wobei diese Dichtungsnut die Dichtungsausnehmungen dreiseitig umgreift.

Als Montagefläche kann also grundsätzlich diejenige Fläche des Rahmenteils angesehen werden, in und/oder an welcher die Montagedichtung angeordnet ist. Der Montagefläche gegenüberliegend besitzt das Rahmenteil eine Seitenfläche.

Das Rahmenteil besitzt weiterhin zu seiner Befestigung in oder an dem Schaltschrank eine Befestigungseinrichtung, beispielsweise Schraubdurchlässe mit dazugehörigen Schrauben oder auch eine im Folgenden noch ausführlich beschriebene Schnellbefestigungseinrichtung, zur Befestigung, insbesondere Verschraubung, des Rahmenteils an der Montagewand oder an irgendeiner anderen in der Nähe der Montagewand im Schaltschrank vorhandenen Befestigungsvorrichtung, insbesondere an einer Anschraubvorrichtung, z.B. an Befestigungsschienen oder dergleichen.

In einer vorteilhaften Ausgestaltung können die Schraubdurchlässe dazu insbesondere an der besagten Seitenfläche beginnen und durch das Rahmenteil hindurch verlaufen und an der Montagefläche des Rahmenteils enden. Beispielsweise kann das Rahmenteil mittels in die Schraubdurchlässe eingefügter Schrauben von innen oder von außen an der Montagewand des Schaltschranks geschraubt werden.

Wie bereits angedeutet, kann in einer dazu alternativen Ausgestaltung als Befestigungseinrichtung statt einer Verschraubung auch eine . Schnellbefestigungseinrichtung folgendermaßen verwendet werden:
Sowohl an dem Rahmenteil als auch an der Montagewand können dazu mindesten ein, bevorzugt mehrere, insbesondere zwei, insbesondere rechteckige Rastfenster vorgesehen sein. Die Rastfenster der Montagewand können in Größe und Form den Rastfenstern des Rahmenteils entsprechen und zu deren gegenseitiger Befestigung bei der Montage direkt übereinanderliegen.

In einer bevorzugten Ausgestaltung kann das Rahmenteil mindestens einen, bevorzugt mehrere, insbesondere zwei Befestigungsflansch(e) aufweisen, in denen jeweils eines der besagten Rastfenster des Rahmenteils angeordnet ist.

Weiterhin sind zur Befestigung eines Rahmenteils mindestens eine, bevorzugt mehrere, insbesondere zwei Schnellbefestigungseinrichtung(en) vorgesehen. Diese besitzen jeweils ein Rastgehäuse, welches bevorzugt formschlüssig durch die Rastfenster hindurchführbar ist.

Weiterhin weisen die Schnellbefestigungseinrichtungen Rastmittel, z.B. im Rastgehäuse federnd gelagerte Rasthaken mit je einer Aufgleitschrägen und einer davon bevorzugt in spitzem Winkel abgewinkelten Rastfläche, auf. So können die Rasthaken beim Hindurchstecken des Rastgehäuses durch die aufeinanderliegenden Rastfenster des Rahmenteils und der Montagewand mittels ihrer Aufgleitschrägen zunächst entgegen der Federkraft in das Rastgehäuse hineingeschoben werden. Durch die Rückstellkraft der Rastfeder werden die Rasthaken dann jedoch im vollständig eingesteckten - d. h. montierten - Zustand von der Rastfeder wieder nach außen gedrückt und rasten mit ihrer Rastfläche hinter dem Rastfenster der Montagewand zur endgültigen mechanischen Befestigung des Rahmenteils an der Montagewand ein. Rahmenteilseitig kann das Rastverbindungsgehäuse dazu bevorzugt eine Anschlagfläche, beispielsweise einen umlaufenden Anschlagflansch, besitzen, mit dem es im montierten Zustand gegen das Rahmenteil, insbesondere gegen den Flansch des Rahmenteils, drückt.

Die Rastfläche des Rasthakens, welche dann von der entgegengesetzten Seite des Rastfensters gegen die Montagewand drückt, muss dabei nicht zwangsläufig parallel zu dieser Anschlagfläche, insbesondere diesem Anschlagflansch, verlaufen. Stattdessen kann er vorteilhafterweise zum Anschlagflansch einen Winkel aufweisen, der etwas größer ist als 0°, bevorzugt größer ist als 2,5° und insbesondere größer ist als 5°. Durch die Rückstellkraft der Rastfeder wird dann die Anschlagfläche, insbesondere der Anschlagflansch, und damit auch der jeweilige Befestigungsflansch des Rahmenteils, durch den Rasthaken gegen die Montagefläche gezogen und hält das Rahmenteil auf diese Weise kraftschlüssig an der Montagewand.

Mit solchen Rastbefestigungsmitteln können die Anbaugehäuse vorteilhafterweise werkzeuglos an einer Gerätewand montiert werden. Zur komfortablen Demontage können diese Rastbefestigungsmittel mittels eines Entriegelungswerkzeugs einfach wieder von der Gerätewand entfernt werden: Beispielsweise kann es sich bei dem Entriegelungswerkzeug um einen L-förmigen Entriegelungsstift handelt, der mit seiner Spitze in eine Entriegelungsöffnung des Rastgehäuses eingeführt und an seinem rechtwinklig abstehenden Hebelbereich betätigt, z.B. gedreht wird, wodurch im Rastgehäuse einen Mechanismus betätigt wird, durch den die Rastelemente entgegen der Federkraft wieder im Rastgehäuse versenkt werden können, um die Befestigung zu lösen.

In einer weiteren Ausgestaltung kann die mindestens eine Schnellbefestigungseinrichtung Bestandteil des Rahmenteils sein, z. B. indem sein Rastgehäuse und sein Anschlagflansch zusammen mit dem Rahmenteil einstückig ausgeführt sind, wodurch die Schnellbefestigungseinrichtung fest mit dem Rahmenteil verbunden ist. In diesem Fall benötigt das Rahmenteil selbst selbstverständlich kein Rastfenster.

Die an der Montagefläche des Rahmenteils angeordnete Montagedichtung ist dabei - entsprechend der Seite der Anbringung von innen oder von außen - gegen die entsprechende Montagewand des Schaltschranks gepresst, wobei die Montagedichtung den zur Kabeldurchführung vorgesehenen Wanddurchbruch in einer vorteilhaften Weiterbildung zumindest dreiseitig umgreift.

In einer bevorzugten Ausgestaltung kann das Rahmenteil eine quaderförmige Grundform besitzen. Die Montagefläche und die Seitenfläche des Rahmenteils können dann parallel zueinander verlaufen und je eine rechteckige Grundform besitzen. Sie können dann über vier im Wesentlichen rechteckige Randflächen des Quaders miteinander verbunden sein. Der Begriff "im Wesentlichen" kann dabei beispielsweise bedeuten, dass zumindest eine der Randflächen durch mindestens eine Ausnehmung unterbrochen ist.

Insbesondere sind die Montagefläche und die Seitenfläche über eine rechtwinklig zu ihnen ausgerichtete Frontfläche des Rahmenteils miteinander verbunden. Diese Frontfläche kann dabei durch eine der besagten Randflächen des Quaders gebildet sein. Im montierten Zustand ist sie zumindest in der Nähe - insbesondere direkt an - einer Schaltschranköffnung angeordnet. Die Frontfläche verläuft eben. Dadurch kann sie im montierten Zustand mit einer frei stehenden Kante der besagten Montagewand, an der sie befestigt ist - und somit auch mit der besagten Schaltschranköffnung - bündig abschließen.

Dabei und im Folgenden ist dem Fachmann klar, dass die Begriffe "plan" sowie "eben" und insbesondere auch "bündig" im Rahmen der üblichen Fertigungs- und Montagetoleranzen und Elastizitäten der entsprechenden Bauteile zu verstehen sind.

Das Rahmenteil weist weiterhin zumindest eine, bevorzugt mehrere, an seiner Frontfläche beginnende und sich in das Rahmenteil hinein erstreckende, konkave U-förmige Dichtungsausnehmung(en) auf. Dadurch ist die Frontfläche des Rahmenteils im Bereich dieser mindestens einen Dichtungsausnehmung unterbrochen.

Die Kabeleinlassvorrichtung besitzt weiterhin mindestens einen elastischen Dichteinsatz. Dieser Dichteinsatz besitzt eine zur Dichtungsausnehmung komplementäre, konvexe U-förmige Einsatzkontur und ist somit form- und kraftschlüssig in die jeweilige Dichtungsausnehmung des Rahmenteils einfügbar.

Jeder Dichteinsatz weist mindestens eine durchgehende, zylindrische Kabeldurchführöffnung sowie einem Einführschlitz zum Einführen eines Kabels in diese Kabeldurchführöffnung auf. Weiterhin besitzt jeder Dichteinsatz an der nicht von seiner konvexen, U-förmigen Einsatzkontur umfassten Seite eine ebene Verschlussfläche, durch welche in einer bevorzugten Weiterbildung der Einführschlitz verlaufen kann. Alternativ kann der Einführschlitz aber auch durch die Einsatzkontur verlaufen.

Wenn der Dichteinsatz endgültig in das Rahmenteil eingesetzt ist, schließt die Verschlussfläche des Dichteinsatzes mit der Frontfläche des Rahmenteils bündig ab. Dann bilden die Frontfläche des Rahmenteils und die Verschlussfläche des Dichteinsatzes - im Rahmen der üblichen Fertigungstoleranzen und Elastizitäten - eine plane, durchgehende Andruckfläche.

Dadurch kann sowohl die Frontfläche des Rahmenteils als auch die Verschlussfläche gleichzeitig und mit besonders hoher Dichtwirkung mittels einer geradlinig verlaufende Gegendichtung abgedichtet werden, indem die Gegendichtung flächig gegen diese Andruckfläche gepresst wird.

In einer vorteilhaften Ausgestaltung ist das Dichtungsverhalten der planen Andruckfläche durch folgende vorteilhafte Ausgestaltung verbesserbar: Das Rahmenteil kann zumindest in seiner Frontfläche beidseitig seiner U-förmigen Dichtungsausnehmungen zusätzliche Vertiefungen, insbesondere lineare Positionierungsausnehmungen, besitzen. In einer bevorzugten Ausgestaltung können diese beiden Positionierungsausnehmungen auch in einer in der gesamten Dichtungsausnehmung angeordneten umlaufenden Rille bestehen oder durch eine solche verbunden sein.

Die Dichteinsätze besitzen dazu komplementäre Positionierungsanformungen, die beim Einfügen des Dichteinsatzes in das Rahmenteil zumindest bereichsweise formschlüssig, insbesondere form- und kraftschlüssig, in die besagten Positionierungsausnehmungen einbringbar sind. Dies dient zum einen der möglichst genauen Positionierung des jeweiligen Dichteinsatzes, also seiner korrekten Ausrichtung und richtigen Lage im Rahmenteil, was für sich genommen bereits einen Vorteil darstellt.

Ein besonders wichtiger weiterer Vorteil besteht zudem in Folgendem: Die zusätzlichen Vertiefungen/ Positionierungsausnehmungen benachbarter Dichtungsausnehmungen können in einer bevorzugten Weiterbildung in der Frontfläche des Rahmenteils direkt aneinander anschließen, so dass auch die Dichtungsausnehmungen über diese Vertiefungen in der Frontfläche miteinander verbunden sind. Sind die Dichtelemente dann nämlich endgültig in das Rahmenteil eingelegt, so schließen sie mit ihren ebenfalls entsprechend verlängerten Positionierungsanformungen direkt aneinander an und können somit auch rahmenseitig eine durchgehende Dichtung bilden. Gleichzeitig schließen sie, wie bereits erwähnt, natürlich auch mit der Frontseite des Rahmenteils plan ab. Durch diese Anordnung kann die Dichtwirkung noch einmal erheblich erhöht werden.

In jedem Fall ist an der Kabeleinlassvorrichtung aus der Frontfläche des Rahmenteils und der Verschlussfläche des Dichteinsatzes eine plane Andruckfläche geschaffen, welche mittels einer geradlinig verlaufende Gegendichtung abgedichtet werden kann, indem die Gegendichtung flächig gegen diese Andruckfläche gepresst wird.

Die Gegendichtung kann dazu auf einem geradlinigen, insbesondere flachen Gegenstand, insbesondere einem Schaltschrankverschließelement, angebracht sein. Das Schaltschrankverschließelement wird im Folgenden noch näher erläutert und dient dem dichten Verschließen des Schaltschranks. Es kann beispielsweise in einer zuklappbaren Schaltschranktür, einem aufrastbaren Schaltschrankdeckel und/oder einem anschraubbaren Blech, beispielsweise der Vorderwand, gebildet sein.

Das Schaltschrankverschließelement kann mit einer bevorzugt daran angebrachten Gegendichtung abdichtend gegen die Andruckfläche, also gegen die Verschlussfläche des mindestens einen Dichtelements und gegen die Frontfläche des mindestens einen, an der Schaltschranköffnung angeordneten Rahmenteils, gepresst werden.

Eine Anordnung weist einen Schaltschrank mit mehreren Schaltschrankwänden - insbesondere mehreren, bevorzugt vier Seitenwänden, einer Front- und einer Rückwand - darunter einer Montagewand auf. Die Montagewand zeichnet sich jeweils dadurch aus, dass sie den besagten Wanddurchbruch/ die besagten Wanddurchbrüche zur Durchführung der einzuführenden Kabel besitzt.

Mehrere der Schaltschrankwände, beispielswiese die vier Seitenwände oder drei der Seitenwände und eine Rückwand, etc., besitzen im geöffneten Zustand des Schaltschranks je eine frei stehende Kante. Diese freistehenden Kanten bilden gemeinsam eine Schaltschranköffnung. Eine dieser mehreren Schaltschrankwände ist die Montagewand. Diese Montagewand zeichnet sich dadurch aus, dass sie Wanddurchbrüche besitzt. Diese Wanddurchbrüche sind in der Montagewand in der Nähe ihrer frei stehenden Kante, also in der Nähe der Schaltschranköffnung, angeordnet. Insbesondere können die Wanddurchbrüche offen ausgeführt sein, also direkt an der frei stehenden Kante der Montagewand und somit direkt an der Schaltschranköffnung angeordnet sein.

Die Schaltschranköffnung kann üblicherweise zur Ermöglichung der händischen Bestückung und Verkabelung des Schaltschranks durch entsprechend geschultes Fachpersonal genutzt werden. Wenn der Schaltschrank bestückt und verkabelt ist, muss die Schaltschranköffnung - und damit der komplette Schaltschrank - wasserdicht verschlossen werden. Dazu besitzt der Schaltschrank das besagte Schaltschrankverschließelement.

Bei diesem Schaltschrankverschließelement kann es sich beispielsweise, wie bereits erwähnt, um eine verbleibende - also nicht zur Gruppe der besagten mehreren, die Schaltschranköffnung bildenden Schaltschrankwände gehörende - Seitenwand oder auch um die Front- oder die Rückwand handeln. Insbesondere kann diese in Form einer beispielsweise an der Schaltschranköffnung angebrachte, zuklappbare Schaltschranktür und/oder ein mit dem Schaltschrank an der Schaltschranköffnung verschraubbares Blech und/oder einen an der Schaltschranköffnung verrastbaren Schaltschrankdeckel, o.ä. ausgeführt sein.

In einer bevorzugten Ausgestaltung handelt es sich bei dem Schaltschrankverschließelement um eine Seitenwand des Schaltschranks. Als Montagewand kann dann beispielsweise die Rückwand vorgesehen sein.

Die mindestens eine Kabeleinlassvorrichtung kann innerhalb, d.h. "von innen" oder außerhalb, also "von außen" des Schaltschranks am Schaltschrank angebracht sein. Insbesondere kann sie an dem Wanddurchbruch von innen oder von außen an der besagten Montagewand angebracht und mit ihrer Montagedichtung abdichtend gegen die Montagewand des Schaltschranks gepresst sein.

Die besagte Andruckfläche der Kabeleinlassvorrichtung kann an und parallel zu einer frei stehenden Kante dieser besagten Montagewand angeordnet sein und somit an die Schaltschranköffnung grenzen, also plan damit abschließen.

Dadurch ist es möglich, das Schaltschrankverschließelement beim Schließvorgang mit einer am Schaltschrankverschließelement angebrachten, geradlinig verlaufenden Gegendichtung gegen die Andruckfläche, also gleichzeitig gegen die Frontfläche des Rahmenteils und gegen die Verschlussfläche des Dichteinsatzes, zu pressen und dadurch abzudichten. Gleichzeitig ist die Montagefläche des Rahmenteils mit seiner Montagedichtung gegen die besagte Montagewand des Schaltschranks gepresst. Die in den Schaltschrank eingeführten Kabel sind dabei durch den in mindestens einen in der Montagewand vorhandenen und von der Montagedichtung abgedichteten Wanddurchbruch geführt und verlaufen ebenfalls abgedichtet und zudem in einem gewissen Maße zugentlastet durch die Kabeldurchführöffnung des jeweiligen Dichtensatzes. Somit ist der gesamte Schaltschrank durch das Schließen des Schaltschrankverschließelements verschlossen und abgedichtet.

Je nach Bauform des Schaltschranks kann es zur besonders starken Abdichtung entweder sinnvoll sein, für die Kabeleinlasseinrichtung eine separate Gegendichtung an dem Schaltschrankverschließelement anzubringen, oder, beispielsweise aus Kostengründen, eine bereits an dem Schaltschrankverschließelement, standardmäßig vorgesehene, also bereits vorhandene, Dichtung als Gegendichtung zu verwenden.

Ein Verfahren zum Betrieb einer solchen Anordnung weist folgende Schritte auf:
A. Befestigen mindestens einer Kabeleinlassvorrichtung mit ihrem Rahmenteil von innen oder von außen an der Montagewand des Schaltschranks im Bereich des dazugehörigen in der Montagewand angeordneten Wanddurchbruchs und direkt an der Schaltschranköffnung des Schaltschranks, so dass die Frontfläche des mindestens einen Rahmenteils mit einer frei stehenden Kante der Montagewand - und dadurch auch mit der Schaltschranköffnung des Schaltschranks - bündig abschließt;
B. Einsetzten mindestens eines Kabels in jeweils einen dazu passenden Dichteinsatz;
C. form- und kraftschlüssiges Einfügen des mindestens einen Dichteinsatzes in jeweils eine Dichtungsausnehmung des mindestens einen Rahmenteils, so dass die Verschlussfläche des mindestens einen Dichteinsatzes mit der Frontfläche des Rahmenteils plan abschließt;
D. Verschließen der Schaltschranköffnung des Schaltschranks mit dem Schaltschrankverschließelement, wobei die daran befestigte, geradlinig verlaufende Gegendichtung durch das Schaltschrankverschließelement abdichtend gegen die Andruckfläche der Kabeleinlassvorrichtung gepresst wird.

Die Kabeleinlassvorrichtung besteht im Wesentlichen aus nur wenigen, und zudem preisgünstig zu fertigenden Teilen. Somit braucht die Kabeleinlassvorrichtung in vorteilhaften Ausgestaltungen lediglich ein Rahmenteil, z.B. aus spritzgegossenem Kunststoff mit einem oder mehreren darin eingefügten Dichtungseinsätzen, z. B. aus Gummi, Kautschuk und/oder Silicon o. ä., aufzuweisen. Damit ist sie besonders unaufwändig zu fertigen, was auch für ihre Herstellung von besonderem Vorteil ist.

Ein besonderer Vorteil der Erfindung besteht somit darin, dass die Kabel im Konfektionsprozess werkzeuglos in den Schaltschrank eingesetzt werden können. Insbesondere kann die Installation der Kabel werkzeuglos durchgeführt werden. Die endgültige Abdichtung der Kabeleinlassvorrichtung kann dabei automatisch erfolgen, insbesondere indem die Schaltschranktür einfach nur geschlossen wird.

Ein weiterer Vorteil der Erfindung besteht somit in der einfachen Handhabbarkeit. Die Installation umfasst lediglich, dass das oder die Rahmenteile im Schaltschrank angebracht und die Kabel in richtiger Länge mit den Dichteinsätzen versehen eingefügt werden.

Ein zusätzlicher Vorteil besteht darin, dass Kabel nachträglich mit nur geringstem Aufwand ergänzt oder gegen andere Kabel ausgetauscht werden können, wenn beispielsweise Kabel unterschiedlicher Querschnitte/ unterschiedlicher Anzahl im Schaltschrank benötigt werden.

Ein besonders großer zusätzlicher Vorteil der Erfindung besteht darin, dass auf diese Weise eine besonders große Anzahl von Kabeln in den Schaltschrank eingeführt werden können. Schließlich steht - anders als im Stand der Technik bekannt - durch die Erfindung eine vollständige Kantenlänge der Schaltschranköffnung zur Bestückung mit Kabeln zur Verfügung. Diese kann - ja nach Ausführung des Schaltschranks - eine Vielzahl von Kabeleinlasseinrichtungen mit jeweils mehreren Dichteinsätzen aufweisen. Von besonderem Vorteil ist dabei, dass sich die Zahl der einführbaren Kabel dadurch automatisch an die Größe des Schaltschranks anpasst.

Weiterhin können auch häufige Wechsel und Änderungen der Bestückung des Schaltschranks - und damit auch seiner Verkabelung - mit geringstmöglichem Aufwand schnell und unaufwändig umgesetzt werden.

Im Gegensatz zu aus dem Stand der Technik bekannten Anordnungen erfolgt das Verschließen der Kabeleinlassvorrichtung nicht durch ein separates Kabeleinlassvorrichtungselement wie beispielsweise einen separaten Riegel. Somit entfällt die Notwendigkeit eines solchen Riegels zum Abschluss des Rahmenteils und zur kraftschlüssigen Fixierung der Dichteinsätze durch die Kabeleinlassvorrichtung. Dies vereinfacht die Montage und verbilligt die Herstellung der Kabeleinlassvorrichtung aus Produktsicht. Stattdessen erfolgt das Verschließen der Kabeleinlassvorrichtung kostengünstigerweise durch ein übliches Schaltschrankverschließelement, welches im Stand der Technik zum Verschließen des Schaltschranks ohnehin vorgesehen ist, aber durch die Kabeleinlassvorrichtung folgendermaßen eine zusätzliche Anwendung erfährt:
Beim Verschließen des Schaltschranks kann dieses Schaltschrankverschließelement nämlich zur Abdichtung insbesondere mit seiner Gegendichtung gegen den mindestens einen Dichtungseinsatz der mindestens einen Kabeleinführeinrichtung gepresst werden. Dadurch kann dieser Dichteinsatz leicht komprimiert werden, wodurch er weiterhin auch in der Lage ist, das mindestens eine hindurchgeführte Kabel zu fixieren und abzudichten. Dabei werden also mittels einer einzigen Aktion - nämlich dem Schließen des Schaltschrankverschließelements, z.B. der Schaltschranktür - gleichzeitig zwei Funktionen erfüllt, nämlich:
A.) den Schaltschrank abzuschließen und abzudichten, und
B.) die Kabeleinlassvorrichtung zu verschließen, nach außen abzudichten, um das/die hindurchgeführte(n) Kabel darin abzudichten und insbesondere auch darin zu fixieren.

In einer vorteilhaften Ausgestaltung kann der mindestens eine Dichteinsatz zumindest einen - bevorzugt zwei beidseitig seiner Verschlussfläche angeordnete - Kragen zum zumindest einseitigen Kontakt mit und insbesondere zum beidseitigen Umgreifen der Gegendichtung besitzen. Dabei ist es in einer bevorzugten Ausgestaltung besonders vorteilhaft, wenn die Gegendichtung, während sie gegen die Verschlussfläche gepresst wird, automatisch form- und kraftschlüssig an zumindest einen der Kragen gedrückt, und insbesondere form- und kraftschlüssig zwischen die beiden Kragen eingefügt ist, weil sie so zusammen mit dem Dichteinsatz eine besonders gute Dichtwirkung entfalten kann.

In einer aus Kompatibilitätsgründen vorteilhaften Ausgestaltung kann die Kabeleinlassvorrichtung mehrere in ihrer Außenkontur zueinander gleichförmige Dichteinsätze aufweisen und das Rahmenteil kann mehrere, zueinander gleichförmige Dichtungsausnehmungen aufweisen. Dabei ist die "Außenkontur" der Dichteinsätze aus ihrer Dichtkontur und der Kontur ihrer Verschlussfläche gebildet.

Weiterhin können sich in einer weiteren bevorzugten Ausgestaltung zumindest zwei der Dichteinsätze durch Anzahl und/oder Durchmesser ihrer Kabeldurchführöffnungen unterscheiden. Dadurch können Kabel mit unterschiedlichen Querschnitten von den genannten Vorteilen der Kabeleinführeinrichtung profitieren. Weiterhin kann ein Dichteinsatz auch zur Durchführung mehrerer Kabel bevorzugt kleinerer Querschnitte eingesetzt werden, was der Befriedigung eines grundsätzlich vorliegenden Bedürfnisses nach einer Erhöhung der Anzahl in den Schaltschrank einzuführender Kabel vorteilhaft entgegenkommt.

Zumindest einer der Dichteinsätze kann an seiner mindestens einen Kabeldurchführöffnung zumindest einseitig einen - insbesondere kreisförmig umlaufenden - Haltekragen zur Erhöhung der Haltekraft zur Fixierung des hindurchgeführten Kabels besitzen. Der Außendurchmesser des umlaufenden Haltekragens kann sich zu seinem frei stehenden Endbereich hin verstärken. Insbesondere kann der Haltekragen trichterförmig ausgeführt sein, also z. B. einen Trichter aufweisen. Durch die besagte Erhöhung des Außendurchmessers kann das hindurchgeführte Kabel mittels eines ringförmigen Fixierelements, beispielsweise einer verschraubbaren Schelle und/oder eines Kabelbinders o. ä., zur Zugentlastung am Dichteinsatz mit besonders hoher Haltekraft befestigt werden, wobei ein unerwünschtes Lösen des ringförmigen Fixierelements vom Haltekragen verhindert ist. Die Haltekraft der ohnehin bereits existierenden Zugentlastung kann dadurch deutlich erhöht werden.

In einer bevorzugten Ausgestaltung kann der mindestens eine Dichteinsatz eine besonders vorteilhafte Shorehärte von 30-40 shore aufweisen. Diese Shorehärte hat den Vorteil, dass der Dichteinsatz eine vergleichsweise hohe Elastizität besitzt, wodurch er folgende Problematik besonders vorteilhaft löst:
Einerseits soll die Verschlussfläche besonders plan ausgeführt sein, um Spalten zwischen der Kabeleinlassvorrichtung und der geradlinigen Gegendichtung zu vermeiden. Andererseits soll aber auch die Handhabung einer bauartbedingte Toleranz der Kabelquerschnitte gewährleistet sein. In der Praxis können die Durchmesser der verwendeten Kabel Abweichungen aufweisen, wobei diese Abweisungen - je nach Kabelstärke - z.B. zwischen 1,5 und 2 mm liegen können. Somit kann für Dichteinsätze mit nur einer Kabeldurchführöffnung, die üblicherweise für stärkere Kabel vorgesehen ist, mit Toleranzen von etwa 2 mm gerechnet werden. Bei Dichteinsätzen mit mehreren Kabeldurchführöffnungen, die zwangsläufig einen kleineren Durchmesser besitzen, ist eher mit Abweichungen von etwa 1,5 mm zu rechnen. Daher ist zur Abdichtung eine relativ hohe Elastizität und somit die besagte Shorehärte von 30-40 shore sinnvoll.

In vielen Fällen soll der mindestens eine Dichteinsatz aber auch ohne den Einsatz des besagten ringförmigen Fixierelements für eine ausreichende Zugentlastung des hindurchgeführten Kabels sorgen.

Dazu kann der Dichteinsatz in einer weiteren vorteilhaften Ausgestaltung innerhalb seiner mindestens einen zylindrischen Kabeldurchführöffnung zumindest eine innere, sogenannte "Dichtrippe", d.h., z.B. eine innere, umlaufende Wulst, aufweisen. Dies ist insbesondere in Zusammenhang mit seiner - insbesondere hohen - Elastizität sinnvoll, weil sich durch diese hohe Elastizität in der Regel zunächst leider auch die Haltekraft gegenüber dem durchgeführten Kabel verringert, was jedoch durch das Vorhandensein einer, bevorzugt mehrerer, solcher Dichtrippen vorteilhaft wieder ausgeglichen werden kann. Das Vorhandensein mehrerer Dichtrippen statt nur einer Dichtrippe hat zudem den Vorteil, dass sich dadurch nicht nur die Haltekraft, sondern auch die Dichtwirkung gegenüber der Verwendung nur einer Dichtrippe in der Regel erhöht.

### Ausführungsbeispiel

Ein Ausführungsbeispiel der Erfindung ist in den Zeichnungen dargestellt und wird im Folgenden näher erläutert. Es zeigen:
- Fig. 1a - e: einen Schaltschrank mit mehreren Kabeleinlasseinrichtungen in verschiedenen Ansichten;
- Fig. 2a - d: eine erste Kabeleinlasseinrichtung mit einem Rahmenteil und einem Dichteinsatz in verschiedenen Ansichten;
- Fig. 2e - f: den Dichteinsatz als separates Einzelteil in verschiedenen Ansichten;
- Fig. 3a: ein zweites Rahmenteil als separates Einzelteil;
- Fig. 3b - c: eine zweite Kabeleinlasseinrichtung mit dem zweiten Rahmenteil und vier verschiedenen Dichteinsätzen in verschiedenen Ansichten;
- Fig. 3d, e: die zweite Kabeleinlasseinrichtung mit geänderter Bestückung in verschiedenen Ansichten;
- Fig. 3f: die zweite Kabeleinlasseinrichtung mit einer Gegendichtung;
- Fig. 4a: einen einzelnen modifizierten Dichteinsatz;
- Fig. 4b: eine dritte Kabeleinlasseinrichtung mit drei modifizierten Dichteinsätzen.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

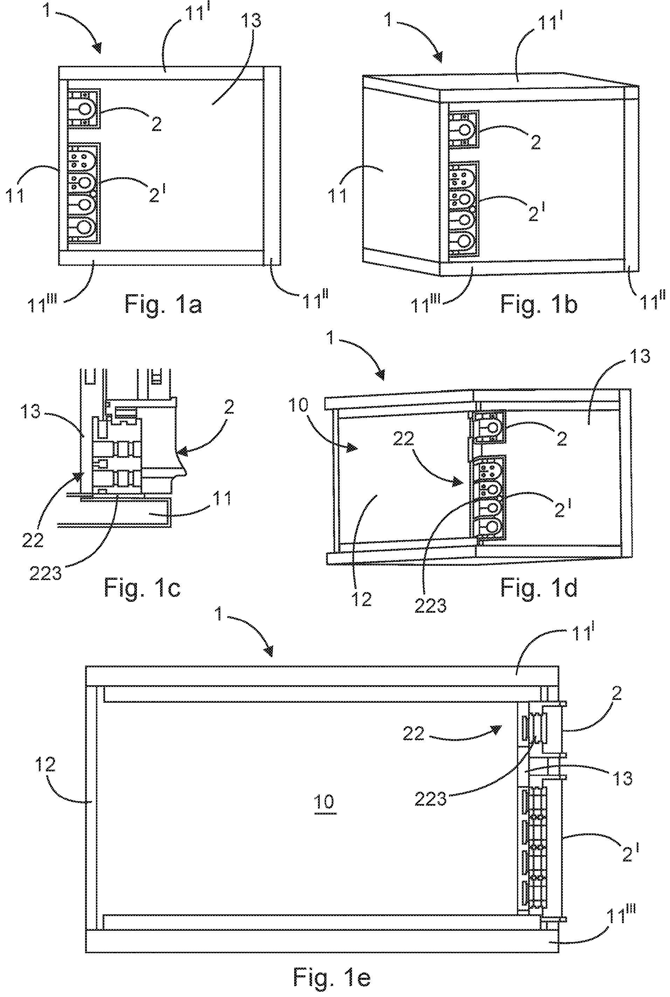

Die Fig. 1a bis 1e zeigen eine Anordnung aus einen Schaltschrank 1 mit mehreren von außen daran angeschraubten Kabeleinlassvorrichtungen 2, 2', nämlich einer ersten und einer zweiten Kabeleinlassvorrichtung 2, 2'. Dabei ist zu beachten, dass diese Darstellung schematisch ist und lediglich den prinzipiellen Aufbau der Anordnung möglichst anschaulich beschreibt. In anderen, besonders realistischen Ausführungen können die Kantenlängen der Schaltschranköffnung noch wesentlich größer ausgeführt sein als bei der gezeigten Schaltschranköffnung 10, wodurch dann noch wesentlich mehr Platz zu Anbringung weiterer Kabeleinlassvorrichtungen 2, 2' existiert.

In der Fig. 1a ist der Schaltschrank 1 mit senkrechtem Blick auf seine Rückwand 13 dargestellt, an welche die Kabeleinlassvorrichtungen 2, 2' von außen angeschraubt sind.

Weiterhin besitzt der Schaltschrank 1 vier Seitenwände 11, 11', 11", 11‴ von denen eine erste Seitenwand 11 in der Fig. 1b besonders gut zu sehen ist und als Schaltschrankverschließelement fungiert, also die Schaltschranköffnung 10 in dieser Darstellung verschließt.

Die Fig. 1c zeigt eine Draufsicht auf einen Schnitt durch die erste Kabeleinlassvorrichtung 2. Dabei ist deutlich zu sehen, wie die erste Seitenwand 11 über die Rückwand 13 hinausragt, um abdichtend gegen eine Verschlussfläche 223 eines Dichteinsatzes 22 der Kabeleinführeinrichtung 2 gepresst zu werden.

In der Fig. 1d ist eine Schaltschranköffnung 10 zu sehen, da die erste Schaltschrankwand 11 entfernt wurde. Durch diese Schaltschranköffnung 10 ist der Blick auf die Innenseite einer Vorderwand 12 des Schaltschranks 1 freigegeben. Aus dieser Ansicht ist weiterhin besonders gut zu erkennen, dass die Kabeleinlassvorrichtungen 2, 2' jeweils an einem seitlichen Wanddurchbruch der Rückwand 13 angebracht sind, welcher sich direkt an einer freistehenden Kante der Rückwand 13 befindet, wodurch der Wanddurchbruch zur Schaltschranköffnung 10 hin offen ausgeführt ist.

Die Fig. 1e zeigt die selbe Anordnung mit senkrechtem Blick auf die Schaltschranköffnung 10.

Die Rückwand 13 des Schaltschranks 1 dient in dieser Ausführung als Montagewand. Die Rückwand 13 besitzt daher die seitlichen Wanddurchbrüche, an deren Bereich jeweils eine Kabeleinlassvorrichtung 2, 2', in diesem Fall von außen, angebracht ist. In einer alternativen Ausführung könnten dieselben Kabeleinlassvorrichtungen 2, 2' allerdings auch von innen, d.h. innerhalb des Schaltschranks 1, an die Rückwand 13 angebracht sein. Durch Verschließen des Schaltschranks 1 mittels der ersten Seitenwand 11 erfolgt die Abdichtung der Kabeleinlassvorrichtungen 2, 2' und damit auch die endgültige Abdichtung des Schaltschranks 1.

In anderen, hier nicht gezeigten, Schaltschrankausführungen könnten dieselben Kabeleinlassvorrichtungen 2, 2' aber beispielsweise auch an Wanddurchbrüchen einer Seitenwand angeordnet sein und von einer Rückwand oder alternativ einer Vorderwand durch deren Verschließen abgedichtet werden. Dann hätte die Rückwand oder die Vorderwand jeweils die Funktion eines Schaltschrankverschließelements, während die Seitenwand, welche dann die Wanddurchbrüche aufwiese, als

Montagewand dienen würde.

Die im Folgenden näher beschriebenen Kabeleinlassvorrichtungen 2, 2",2" sind vorteilhafterweise davon unabhängig und somit äußerst flexibel auch an den vorgenannten und grundsätzlich an verschiedenartigsten Schaltschränken verwendbar.

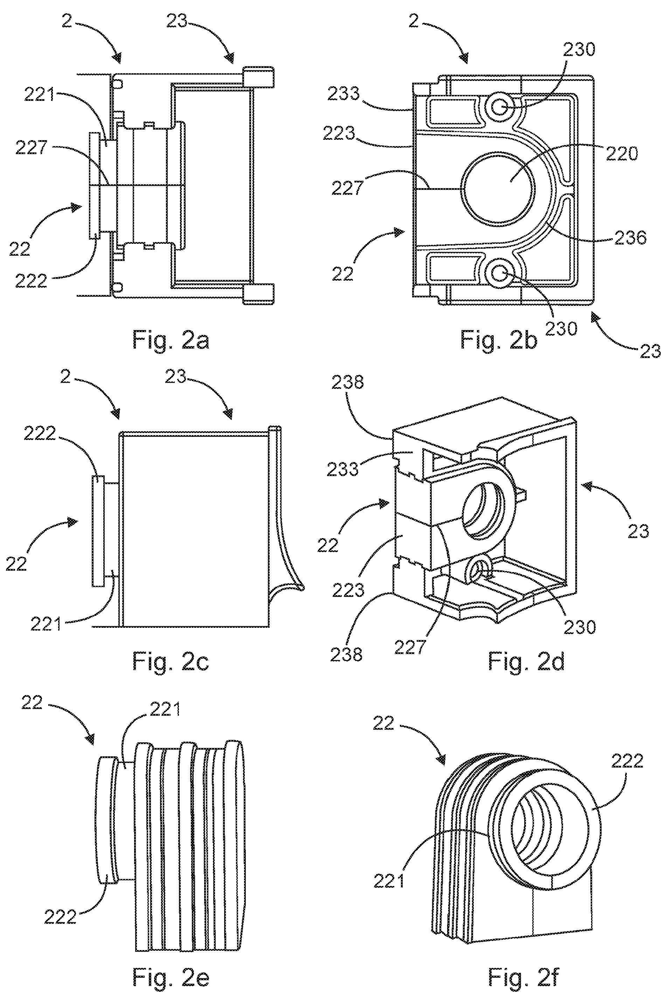

Die Fig. 2a - 2d zeigen die erste Kabeleinlassvorrichtung 2 in vier verschiedenen Ansichten. Diese erste Kabeleinlasseinrichtung 2 besitzt ein Rahmenteil 23 mit nur einer einzigen Dichtungsausnehmung 236 und weist dementsprechend auch nur ein einziges Dichteinsatz 22 auf.

Die Fig. 2a zeigt die erste Kabeleinlasseinrichtung 2 in einem seitlichen Querschnitt. In dieser Darstellung ist gut zu erkennen, dass der Dichteinsatz 22 an seiner Kabeldurchführöffnung 220 einen Haltekragen 221 mit einem Trichter 222 besitzt.

Die Fig. 2b zeigt die erste Kabeleinlasseinrichtung 2 in einer Seitenansicht, nämlich mit Blick auf die nicht mit einem Bezugszeichen versehene Seitenfläche ihres Rahmenteils 23. Aus herstellungstechnischen Gründen weist das Rahmenteil 23 an dieser Seitenfläche Hohlräume auf.

Das Rahmenteil 23 besitzt weiterhin eine rechtwinklig zur Seitenfläche angeordnete ebene Frontfläche 233. Diese Frontfläche 233 ist von der konkaven, U-förmigen Dichtungsausnehmung 236 unterbrochen, welche sich von der Frontfläche 233 aus in das Rahmenteil 23 hinein erstreckt.

Der mit seiner konvexen, U-förmigen Einsatzkontur in die Dichtungsausnehmung 236 form- und kraftschlüssig eingesetzte Dichteinsatz 22 besitzt weiterhin eine ebene Verschlussfläche 223, die mit der Frontfläche 233 des Rahmenteils 23 plan abschließt. Außerdem besitzt der Dichteinsatz 22 eine durchgehende zylindrische Kabeldurchführöffnung 220 sowie einen Einführschlitz 227 zum Einführen eines Kabels in die Kabeldurchführöffnung 220.

Als Befestigungseinrichtung besitzt das Rahmenteil 23 mehrere, in dieser Ausführung zwei, Schraubdurchlässe 230, welche von der Montageseite aus beginnend in Richtung der Seitenfläche, also in der Fig. 2b in Blickrichtung verlaufen.

In einer anderen Ausführung kann die Befestigung des Rahmenteils 23 an der Montagefläche des Schaltschranks 1 statt durch die vorgenannte Verschraubung auch in Form einer Schnellbefestigungstechnik durchgeführt werden, nämlich mittels einer oder mehrerer Schnellbefestigungseinrichtungen, die in der Zeichnung aber nicht dargestellt sind.

Die Fig. 2c zeigt die Kabeleinlassvorrichtung 2 in einer Draufsicht.

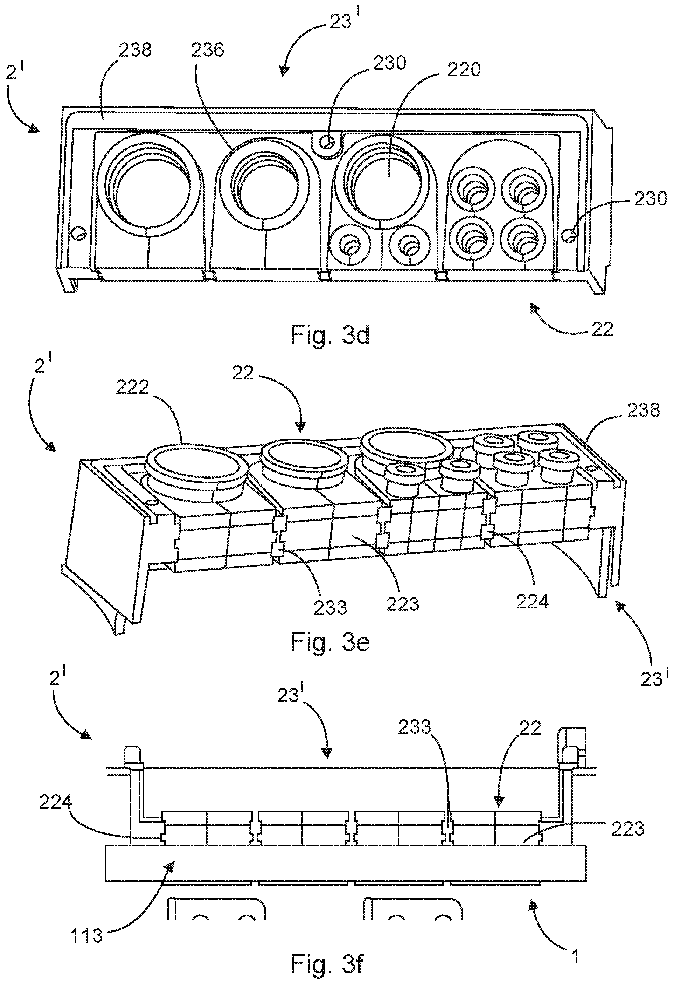

Die Fig. 2d zeigt die Kabeleinlassvorrichtung 2 in einer schrägen Draufsicht auf die besagte, nicht mit einem Bezugszeichen versehene Seitenfläche. Der Seitenfläche gegenüberliegend besitzt das Rahmenteil 23 eine ebenfalls nicht mit einem Bezugszeichen versehene Montagefläche, die zur Montage auf der Montagewand, also in dieser Ausführung der Rückwand 13 des Schaltschranks 1, vorgesehen ist. In der Montagefläche des Rahmenteils 23 ist eine dreiseitig umlaufende Montagedichtung 238 angeordnet, die hier nur andeutungsweise - und in leicht abgewandelter Form besonders gut in den später folgenden Fig. 3d und 3e - zu sehen ist.

Die Fig. 2e und 2f zeigen das Dichtelement 22 als separates Einzelteil. In der Fig. 2e sind der Haltekragen 221 und der Trichter 222 des Dichtelements 22 besonders gut zu sehen.

An dem ringförmig umlaufenden Haltekragen 221 kann ein ringförmiges Fixierelement angeordnet werden, welches nicht in der Zeichnung dargestellt ist. In einer Ausführung handelt es sich bei dem ringförmigen Fixierelement um eine verschraubbare Schelle. In einer anderen Ausführung handelt es sich um einen Kabelbinder. Das Fixierelement dient der Erhöhung der Haltekraft bei der Fixierung des ebenfalls nicht dargestellten, durch die Kabeldurchführöffnung 220 hindurchgeführten Kabels.

Durch den Trichter 222 verstärkt sich der Durchmesser des Haltekragens 221 zu seinem frei stehenden Endbereich hin. Dadurch kann das nicht gezeigte ringförmige Fixierelement unverlierbar am Haltekragen 221 gehalten werden.

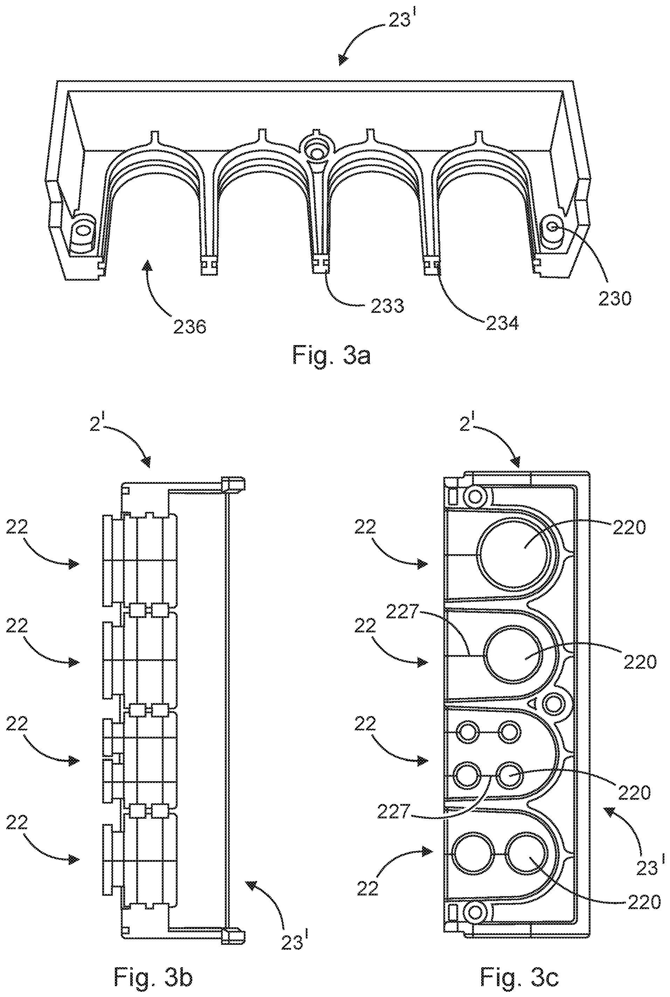

Die Fig. 3a - 3f zeigen eine zweite Kabeleinlasseinrichtung 2'.

Insbesondere ist dazu in der Fig. 3a ein zweites Rahmenteil 23' als separates Einzelteil dargestellt. Dieses 23' besitzt vier gleichförmige Dichtungsausnehmungen 236 der vorgenannten Art. Zwischen den Dichtungsausnehmungen 236 ist die Frontfläche 233 zu sehen. Mit anderen Worten ist die Frontfläche 233 von den Dichtungsausnehmungen 236 mehrfach unterbrochen. An den jeweiligen Dichtungsausnehmungen 236 sind Positionierungsausnehmungen 234 angeordnet. In diesem Fall ziehen sich die Positionierungsausnehmungen jeweils als Rille durch den inneren Rand der gesamten konkave, U-förmige Dichtungsausnehmung 236 und sind mit ihren Enden in der Frontfläche 233 angeordnet.

In die Dichtungsausnehmungen 236 können daraufhin, wie in den Fig. 3b und 3c gezeigt, verschiedene Dichteinsätze 22 eingefügt werden.

Die Dichteinsätze besitzen zumindest an ihrer Verschlussfläche 224 jeweils mindestens eine, in diesem Fall eine um ihre Einsetzkontur umlaufende Positionierungsanformung 224. Diese 224 greift zur exakten Positionierung des jeweiligen Dichteinsatzes 22 im die jeweilige Positionierungsausnehmung 234 der dazugehörigen Dichtungsausnehmung 236 zumindest formschlüssig, und insbesondere form- und kraftschlüssig.

Obwohl sich die vier hier gezeigten Dichteinsätze 22 in Größe und/oder Anzahl ihrer Kabeldurchgangsöffnungen 220 sowie der Länge ihrer Einführschlitze 227 unterscheiden, werden sie mit denselben Bezugszeichen versehen, da sie einander gleichen und zudem auch eine vergleichbare Funktion besitzen.

Die Fig. 3d und 3e zeigen weiterhin die zweite Kabeleinlasseinrichtung 2', aber mit dem geringfügigen Unterschied, dass einige der Dichteinsätze 22 gegenüber den vorangegangenen Darstellungen vertauscht oder gegen andere Dichteinsätze 22 ausgetauscht sind.

Da diese Dichteinsätze 22 zueinander eine gleiche Grundform, also die gleiche U-förmige Einsatzkontur und die gleiche Verschlussfläche 223, besitzen, und weiterhin auch die Dichtungsausnehmungen 236 der Rahmenteile 23, 23', 23" miteinander übereinstimmen, sind diese Dichteinsätze 22 nämlich je nach Anforderung beliebig gegeneinander austauschbar, was aus Kompatibilitätsgründen selbstverständlich äußerst vorteilhaft ist.

In diesen beiden Darstellungen ist auch die bereits kurz erwähnte Montagedichtung 238 des Rahmenteils 23 gut zu sehen. Die Montagedichtung 238 ist in einer U-förmigen Dichtnut der Montageseite gehalten und umgreift die Dichtungsausnehmungen 236 dreiseitig. Durch die Montagedichtung 238 wird die Montagefläche definiert, d.h. als Montagefläche ist somit diejenige Außenfläche des Rahmenteils 2' anzusehen, in welcher die Montagedichtung 238 angeordnet ist.

Schließlich ist das Rahmenteil 23 dafür vorgesehen, mit seiner Montagefläche, und somit auch mit seiner Montagedichtung 238, im Bereich des jeweiligen Wanddurchbruchs abdichtend gegen die Montagewand, also in diesem Fall gegen die Rückwand 13 des Schaltschranks 1, gepresst zu werden.

Die Fig. 3f zeigt die zweite Kabeleinführeinrichtung 2' in ihrem an den Schaltschrank 1 angebauten und abgedichteten Zustand mit Blick aus Richtung des Schaltschrankverschließelements, also in diesem Fall des ersten Seitenteils 11, im Schnitt durch eine geradlinig verlaufende Gegendichtung 113, die innenseitig am Schaltschrankverschließelement (Seitenteil 11) angebracht ist.

Dabei ist leicht vorstellbar, wie die Gegendichtung 113 durch das Verschließen des Schaltschranks mittels des Schaltschrankverschließelements - also in dieser Ausführung mit der Seitenwand 11 - gegen eine ebene Andruckfläche der Kabeleinlassrichtung 2' gepresst wird, wobei die Andruckfläche aus der Frontfläche 233 des Rahmenteils 23 und der Verschlussfläche 223 der Dichteinsätze 22 gebildet ist.

In der gezeigten Darstellung ist die Gegendichtung 113 schmaler als die besagte Andruckfläche. In einer anderen Ausführung kann die Gegendichtung 113 aber auch ebenso breit sein, wie die Verschlussfläche 223 der Dichteinsätze 22.

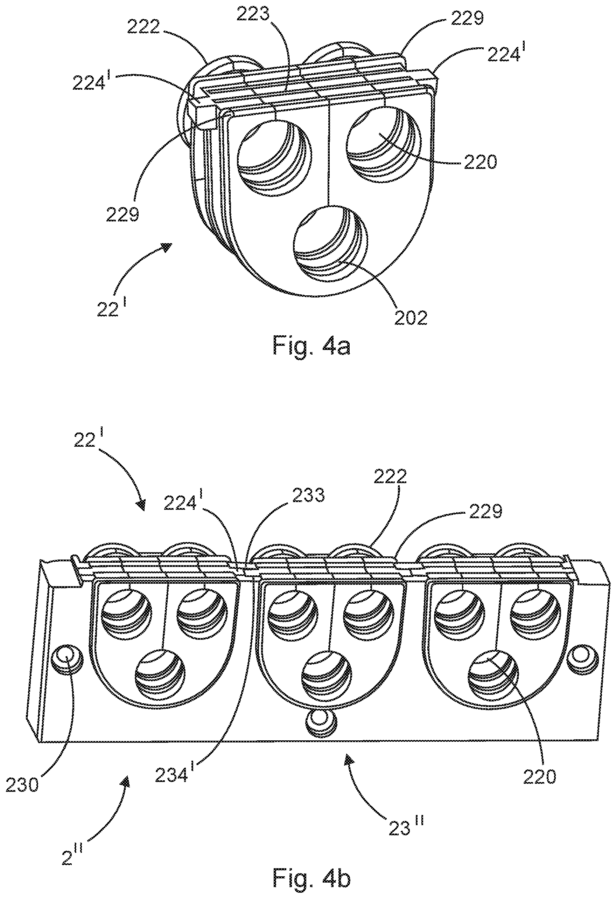

In der Fig. 4a ist ein geringfügig modifizierter Dichteinsatz 22' in einer geringfügig abgewandelten Ausführungsform gezeigt. Dieser besitzt eine besonders hohe Dichtwirkung. Er weist beidseitig der Verschlussfläche 223 je einen geradlinig verlaufenden Kragen 229 auf. Ist nun, wie vorstehend angedeutet, die Gegendichtung 113 ebenso breit wie die Verschlussfläche 223, so kann die Gegendichtung 113 formschlüssig und insbesondere auch form- und kraftschlüssig zwischen den beiden Kragen 229 eingefügt und gegen die Verschlussfläche 223 gepresst werden, wodurch die Qualität der Dichtung erheblich verbessert wird. Doch auch bei nur einseitigen Kontakt der Gegendichtung 113 mit einem der beiden Kragen 229 tritt eine deutliche Verbesserung der Dichtwirkung ein.

Zudem besitzt der modifizierte Dichteinsatz 22', wie auch der davor genannte Dichteinsatz 22, innerhalb seiner Kabeldurchgangsöffnung 220 zwei Dichtrippen 202. Dadurch bleibt eine ausreichende Haltekraft gegenüber einem hindurchgeführten Kabel auch dann gewährleistet, wenn der Dichteinsatz 22' aus einem besonders elastischen Material, z.B. mit einer Shorehärte von 20-30 shore, besteht.

Weiterhin sind die Positionierungsanformungen 224' gegenüber der vorgenannten Ausführung zumindest im Bereich der Verschlussfläche 223 etwas verlängert.

Aus der Fig. 4b wird mit Blick auf die Seitenfläche einer dritten Ausführung des Rahmenteils 23" einer dritten Kabeleinlassvorrichtung 2" folgendes ersichtlich:
Auch in der Frontfläche 233 des dritten Rahmenteils 23" sind die Positionierungsausnehmungen 234' gegenüber der vorgenannten Ausführung vergrößert und schließen direkt aneinander an. Dadurch schließen auch die Positionierungsanformungen 224' benachbarter Dichteinsätze 22' im eingebauten Zustand direkt aneinander an, was im abgedichteten Zustand, also bei dagegen gepresster Gegendichtung 113, eine besonders starke Abdichtung ermöglicht.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1: Schaltschrank
- 11, 11', 11", 11‴: Seitenwände
- 12: Vorderwand
- 13: Rückwand

- 2, 2', 2'': Kabeleinlasseinrichtung

- 22, 22': (modifizierter) Dichteinsatz
- 220: Kabeldurchführöffnung
- 221: Haltekragen
- 222: Trichter
- 223: Verschlussfläche
- 224, 224': Positionierungsanformungen
- 227: Einführschlitz
- 229: Kragen

- 23, 23', 23": Rahmenteil
- 230: Schraubdurchlass
- 233: Frontfläche
- 234, 234': Positionierungsausnehmungen
- 236: Dichtungsausnehmung

## Patentansprüche

1. Anordnung, aufweisend mindestens eine Kabeleinlassvorrichtung (2, 2', 2") sowie einen Schaltschrank (1) mit einer Schaltschranköffnung (10)
wobei die mindestens eine Kabeleinlassvorrichtung (2, 2', 2") in oder an dem Schaltschrank (1) im Bereich eines Wanddurchbruchs einer Montagewand (13) des Schaltschranks (1) angebracht und mit einer Montagedichtung (238) abdichtend gegen diese Montagewand (13) gepresst ist,
wobei die Montagedichtung (238) den jeweiligen Wanddurchbruch zumindest dreiseitig umgreift
wobei die Kabeleinlassvorrichtung (2, 2', 2") folgendes aufweist:
- ein starres Rahmenteil (23, 23', 23"), welches zu seiner Befestigung in dem Schaltschrank (1) eine Befestigungseinrichtung besitzt,
- wobei das Rahmenteil (23, 23', 23") einerseits eine Montagefläche mit der Montagedichtung (238) zur Abdichtung gegenüber einer dafür als Montagewand vorgesehenen Schaltschrankwand (13) besitzt, und
- wobei das Rahmenteil (23, 23', 23") andererseits eine der Montagefläche gegenüberliegende Seitenfläche besitzt, wobei die Montagefläche und die Seitenfläche über eine Frontfläche (233) miteinander verbunden sind,
- wobei die Frontfläche (233) eben verläuft, um im montierten Zustand an der Schaltschranköffnung (10) des Schaltschranks (1) mit einer frei stehenden Kante der besagten Montagewand (13) plan abzuschließen,
- wobei das Rahmenteil (23, 23', 23'') zumindest eine, an der Frontfläche (233) beginnende und sich in das Rahmenteil (23, 23', 23") hinein erstreckende, konkave, U-förmige Dichtungsausnehmung (236) aufweist,
- und wobei die Kabeleinlassvorrichtung (2, 2', 2") weiterhin mindestens einen, mit seiner dazu komplementären, konvexen, U-förmigen Einsatzkontur form- und kraftschlüssig in die jeweilige Dichtungsausnehmung (236) des Rahmenteils (23, 23', 23") einfügbaren, elastischen Dichteinsatz (22, 22') besitzt,
- wobei der mindestens eine Dichteinsatz (22, 22') mindestens eine durchgehende zylindrischen Kabeldurchführöffnung (220) sowie je einem Einführschlitz (227) zum Einführen eines Kabels in die Kabeldurchführöffnung (220) aufweist, und
- wobei jeder Dichteinsatz (22, 22') weiterhin eine ebene Verschlussfläche (223) besitzt,
- wobei diese Verschlussfläche (223) des mindestens einen Dichteinsatzes (22, 22') in dessen eingefügtem Zustand mit der Frontfläche (233) des Rahmenteils (23, 23', 23") plan abschließt, **dadurch gekennzeichnet, dass**
der jeweilige Wanddurchbruch direkt an der Schaltschranköffnung (10) angeordnet ist, wobei der Schaltschrank ein Schaltschrankverschließelement (11) besitzt, durch welches die Schaltschranköffnung (10) verschließbar ist und bei dem es sich um eine an der Schaltschranköffnung (10) angebrachte, zuklappbare Schaltschranktür und/oder ein mit dem Schaltschrank (1) an der Schaltschranköffnung (10) verschraubbares Blech, und/oder eine an der Schaltschranköffnung (10) verrastbare Schaltschrankwand (11) des Schaltschranks (1) oder einen an der Schaltschranköffnung (10) verrastbaren Schaltschrankdeckel handelt, wobei der Frontfläche (233) des Rahmenteils (23, 23', 23") zusammen mit den Verschlussflächen (223) ihrer Dichteinsätze (22, 22') plan zu einer frei stehenden Kante der besagten Montagewand (13) an die Schaltschranköffnung (10) grenzt und
so durch das Schaltschrankverschließelement (11) im geschlossenen Zustand gegen eine am Schaltschrankverschließelement (11) befestigte, geradlinig verlaufenden Gegendichtung (113) gepresst und somit abgedichtet ist.

2. Anordnung gemäß Anspruch 1, wobei der mindestens eine Dichteinsatz (22, 22') beidseitig seiner Verschlussfläche (223) jeweils einen, im eingefügten Zustand entlang der ersten Längsseite des Rahmenteils (23, 23', 23") linear verlaufenden Kragen (229) zum beidseitigen, form- und kraftschlüssigen Umgreifen der Gegendichtung (113) besitzt.

3. Anordnung gemäß einem der vorstehenden Ansprüche, wobei die Kabeleinlassvorrichtung (2, 2', 2") zumindest zwei in ihrer Außenkontur zueinander gleichförmige Dichteinsätze (22, 22') aufweist und wobei das Rahmenteil (23, 23', 23") zumindest zwei zueinander gleichförmige Dichtungsausnehmungen (236) aufweist.

4. Anordnung gemäß einem der vorstehenden Ansprüche, wobei sich zumindest zwei der Dichteinsätze (22, 22') durch Anzahl und/oder Durchmesser ihrer Kabeldurchführöffnungen (220) unterscheiden.

5. Anordnung gemäß einem der vorstehenden Ansprüche, wobei zumindest einer der Dichteinsätze (22, 22') an seiner mindestens einen Kabeldurchführöffnung (220) zumindest einseitig einen umlaufenden Haltekragen (221) sowie ein ringförmiges Fixierelement zur Erhöhung der Haltekraft bei der Fixierung des hindurchgeführten Kabels besitzt.

6. Anordnung gemäß Anspruch 5, wobei der Außendurchmesser des umlaufenden Haltekragens (221) sich zu seinem frei stehenden Bereich hin verstärkt, um das ringförmige Fixierelement unverlierbar am Haltekragen (221) zu halten.

7. Anordnung gemäß Anspruch 6, wobei es sich bei dem ringförmigen Fixierelement um eine verschraubbare Schelle oder einen Kabelbinder handelt.

8. Anordnung gemäß einem der vorstehenden Ansprüche, wobei das Material des mindestens eine Dichteinsatzes (22, 22') eine Shorehärte von 30-40 shore aufweist.

9. Anordnung gemäß einem der vorstehenden Ansprüche, wobei der mindestens eine Dichteinsatz (22, 22') innerhalb seiner mindestens einen zylindrischen Kabeldurchführöffnung (220) zumindest eine Dichtrippe (202) aufweist, um trotz der Elastizität des Dichtensatzes (22, 22') eine möglichst hohe Haltekraft gegenüber dem durchgeführten Kabel zu gewährleisten.

10. Anordnung gemäß einem der vorstehenden Ansprüche, wobei das Rahmenteil (23, 23', 23") als Befestigungseinrichtung mehrere Schraubdurchlässe (230) aufweist.

11. Anordnung gemäß einem der Ansprüche 1 bis 9, wobei das Rahmenteil (23, 23', 23") als Befestigungseinrichtung entweder mindestens ein Rastfenster und mindestens eine separate Schnellbefestigungseinrichtung oder mindestens eine fest mit dem Rahmenteil (23, 23', 23") verbundene Schnellbefestigungseinrichtung aufweist.

12. Verfahren zum Betrieb einer Anordnung nach einem der vorstehenden Ansprüche, umfassend folgende Schritte:
A. Befestigen mindestens einer Kabeleinlassvorrichtung (2, 2', 2") mit ihrem Rahmenteil (23, 23', 23") von innen oder von außen an der Montagewand (13) des Schaltschranks (1) an dem dazugehörigen Wanddurchbruch und direkt an der Schaltschranköffnung (10) des Schaltschranks (1), so dass die Frontfläche (233) des mindestens einen Rahmenteils (23, 23', 23") mit einer frei stehenden Kante der Montagewand (13) und dadurch auch mit der Schaltschranköffnung (10) des Schaltschranks (1) bündig abschließt;
B. Einsetzten mindestens eines Kabels in mindestens einen Dichteinsatz (22, 22');
C. form- und kraftschlüssiges Einfügen des mindestens einen Dichteinsatzes (22, 22') in jeweils eine Dichtungsausnehmung (236) des Rahmenteils (23, 23', 23"), so dass die Verschlussfläche (223) des mindestens einen Dichteinsatzes (22, 22') mit der Frontfläche (233) des mindestens einen Rahmenteils (23, 23', 23") plan abschließt;
D. Verschließen der Schaltschranköffnung (10) des Schaltschranks (1) mit dem Schaltschrankverschließelement . (11), wobei die daran befestigte, geradlinig verlaufende Gegendichtung (113) durch das Schaltschrankverschließelement (11) gleichzeitig abdichtend gegen die Verschlussfläche (223) des mindestens einen Dichteinsatzes (22, 22') und gegen die Frontfläche (233) des mindestens einen Rahmenteils (23, 23', 23") gepresst wird.

## Claims

1. Arrangement, having at least one cable inlet device (2, 2', 2") as well as a switchgear cabinet (1) having a switchgear cabinet opening (10),
wherein the at least one cable inlet device (2, 2', 2") is attached in or on the switchgear cabinet (1) in the region of a wall aperture of an assembly wall (13) of the switchgear cabinet (1) and is pressed sealingly with an assembly seal (238) against this assembly wall (13),
wherein the assembly seal (238) surrounds the relevant wall aperture at least on three sides,
wherein the cable inlet device (2, 2', 2") has the following:
- a rigid frame part (23, 23', 23''), which, in order to be fastened in the switchgear cabinet (1), has a fastening device,
- wherein the frame part (23, 23', 23'') on the one hand has an assembly face with the assembly seal (238) for sealing with respect to a switchgear cabinet wall (13) provided for this purpose as an assembly wall, and
- wherein the frame part (23, 23', 23'') on the other hand has a side face opposite the assembly face, wherein the assembly face and the side face are connected to one another via a front face (233),
- wherein the front face (233) runs level, in order, in the state assembled on the switchgear cabinet opening (10) of the switchgear cabinet (1), to terminate in a planar manner with a free edge of said assembly wall (13),
- wherein the frame part (23, 23', 23'') has at least one concave U-shaped seal recess (236) starting on the front face (233) and extending into the frame part (23, 23', 23''),
- and wherein the cable inlet device (2, 2', 2") furthermore has at least one elastic sealing insert (22, 22'), insertable form fittingly and with frictional engagement into the corresponding seal recess (236) of the frame part (23, 23', 23'') by its convex U-shaped insert contour complementary to said seal recess,
- wherein the at least one sealing insert (22, 22') has at least one continuous, cylindrical cable bushing opening (220) and a respective insertion slot (227) for inserting a cable into the cable bushing opening (220), and
- wherein each sealing insert (22, 22') furthermore has a level closing face (223),
- wherein this closing face (223) of the at least one sealing insert (22, 22'), in the inserted state thereof, terminates in a planar manner with the front face (233) of the frame part (23, 23', 23''), **characterized in that** the relevant wall aperture is arranged directly on the switchgear cabinet opening (10), wherein
the switchgear cabinet has a switchgear cabinet closing element (11), by which the switchgear cabinet opening (10) can be closed, and the switchgear cabinet closing element is a switchgear cabinet door that is attached to the switchgear cabinet opening (10) and can be closed shut and/or a plate that can be screwed to the switchgear cabinet (1) at the switchgear cabinet opening (10), and/or a switchgear cabinet wall (11) of the switchgear cabinet (1) that can be latched to the switchgear cabinet opening (10) or a switchgear cabinet lid that can be latched to the switchgear cabinet opening (10), wherein the front face (233) of the frame part (23, 23', 23'') together with the closing faces (223) of its sealing inserts (22, 22') adjoin the switchgear cabinet opening (10) in a manner planar with a free edge of said assembly wall (13) and
is therefore pressed and thus sealed by the switchgear cabinet closing element (11) in the closed state against a counterpart seal (113) fastened to said switchgear cabinet closing element (11) and running in a straight line.

2. Arrangement according to Claim 1, wherein the at least one sealing insert (22, 22') has, arranged on each side of its closing face (223), a collar (229), which in the inserted state runs linearly along the first longitudinal side of the frame part (23, 23', 23''), for engaging around the counterpart seal (113) form-fittingly and with frictional engagement on both sides.

3. Arrangement according to either of the preceding claims, wherein the cable inlet device (2, 2', 2") has at least two sealing inserts (22, 22') that are identical to one another in respect of their outer contour, and wherein the frame part (23, 23', 23'') has at least two seal recesses (236) that are identical to one another.

4. Arrangement according to any one of the preceding claims, wherein at least two of the sealing inserts (22, 22') differ by the number and/or the diameter of their cable bushing openings (220).

5. Arrangement according to any one of the preceding claims, wherein at least one of the sealing inserts (22, 22') has, at its at least one cable bushing opening (220), at least on one side, a peripheral holding collar (221) as well as an annular fixing element for increasing the holding force when fixing the cable guided through.

6. Arrangement according to Claim 5, wherein the outer diameter of the peripheral holding collar (221) increases towards its free region, in order to hold the annular fixing element captively on the holding collar (221).

7. Arrangement according to Claim 6, wherein the annular fixing element is a screwable clamp or a cable tie.

8. Arrangement according to any one of the preceding claims, wherein the material of the at least one sealing insert (22, 22') has a Shore hardness of 30-40 Shore.

9. Arrangement according to any one of the preceding claims, wherein the at least one sealing insert (22, 22') has, within its at least one cylindrical cable bushing opening (220), at least one sealing rib (202), in order to ensure a maximum holding force with respect to the cable guided through, in spite of the elasticity of the sealing insert (22, 22').

10. Arrangement according to any one of the preceding claims, wherein the frame part (23, 23', 23'') has a plurality of screw passages (230) as fastening device.

11. Arrangement according to any one of Claims 1 to 9, wherein the frame part (23, 23', 23'') has, as fastening device, either at least one detent window and at least one separate quick fastening device or at least one quick fastening device fixedly connected to the frame part (23, 23' , 23").

12. Method for operating an arrangement according to any one of the preceding claims, comprising the following steps:
A. fastening at least one cable inlet device (2, 2', 2") with its frame part (23, 23', 23'') from the inside or from the outside to the assembly wall (13) of the switchgear cabinet (1) at the associated wall aperture and directly to the switchgear cabinet opening (10) of the switchgear cabinet (1), so that the front face (233) of the at least one frame part (23, 23', 23'') terminates flush with a free edge of the assembly wall (13) and thus also with the switchgear cabinet opening (10) of the switchgear cabinet (1);
B. inserting at least one cable into at least one sealing insert (22, 22');
C. inserting the at least one sealing insert (22, 22') form fittingly and with frictional engagement into a respective seal recess (236) of the frame part (23, 23', 23"), so that the closing face (223) of the at least one sealing insert (22, 22') terminates in a planar manner with the front face (233) of the at least one frame part (23, 23', 23'');
D. closing the switchgear cabinet opening (10) of the switchgear cabinet (1) by the switchgear cabinet closing element (11), wherein the counterpart seal (113), fastened thereto and running in a straight line, at the same time is pressed sealingly by the switchgear cabinet closing element (11) against the closing face (223) of the at least one sealing insert (22, 22') and against the front face (233) of the at least one frame part (23, 23', 23").

## Revendications

1. Agencement, comprenant au moins un dispositif d'entrée de câble (2, 2', 2") ainsi qu'une armoire de commande (1) pourvue d'une ouverture d'armoire de commande (10),
ledit au moins un dispositif d'entrée de câble (2, 2', 2") étant monté dans ou sur l'armoire de commande (1) dans la zone d'une percée de paroi d'une paroi de montage (13) de l'armoire de commande (1) et étant pressé de manière étanche contre cette paroi de montage (13) à l'aide d'un joint de montage (238),
le joint de montage (238) entourant au moins sur trois côtés la percée de paroi respective,
le dispositif d'entrée de câble (2, 2', 2") présentant les éléments suivants :
- une partie cadre rigide (23, 23', 23") qui possède un dispositif de fixation pour sa fixation dans l'armoire de commande (1),
- la partie cadre (23, 23', 23") possédant d'une part une surface de montage pourvue du joint de montage (238) pour l'étanchéité vis-à-vis d'une paroi d'armoire de commande (13) prévue à cet effet comme paroi de montage, et
- la partie cadre (23, 23', 23") possédant d'autre part une surface latérale opposée à la surface de montage, la surface de montage et la surface latérale étant reliées l'une à l'autre par l'intermédiaire d'une surface frontale (233),
- la surface frontale (233) étant plane afin de se terminer en affleurant, à l'état monté, à l'ouverture d'armoire de commande (10) de l'armoire de commande (1), par un bord libre de ladite paroi de montage (13),
- la partie cadre (23, 23', 23") présentant au moins un évidement d'étanchéité (236) concave, en forme de U, commençant au niveau de la surface frontale (233) et s'étendant à l'intérieur de la partie cadre (23, 23', 23")'
- et le dispositif d'entrée de câble (2, 2', 2") possédant en outre au moins un insert d'étanchéité élastique (22, 22') pouvant être inséré, par complémentarité de forme et de force, dans l'évidement d'étanchéité respectif (236) de la partie cadre (23, 23', 23") par sa forme complémentaire, convexe en forme de U,
- ledit au moins un insert d'étanchéité (22, 22') présentant au moins une ouverture de passage de câble cylindrique (220) ainsi que, dans chaque cas, une fente d'insertion (227) pour l'insertion d'un câble dans l'ouverture de passage de câble (220), et
- chaque insert d'étanchéité (22, 22') possédant en outre une surface de fermeture plane (223),
- cette surface de fermeture (223) dudit au moins un insert d'étanchéité (22, 22') se terminant en affleurant, à l'état inséré, à la surface frontale (233) de la partie cadre (23, 23', 23"), **caractérisé en ce que**
la percée de paroi respective est disposée directement au niveau de l'ouverture d'armoire de commande (10),
l'armoire de commande possédant un élément de fermeture d'armoire de commande (11) par lequel l'ouverture d'armoire de commande (10) peut être fermée, et qui est une porte d'armoire de commande rabattable, montée sur l'ouverture d'armoire de commande (10), et/ou une tôle pouvant être vissée à l'armoire de commande (1) sur l'ouverture d'armoire de commande (10), et/ou une paroi d'armoire de commande (11) de l'armoire de commande (1) pouvant être encliquetée sur l'ouverture d'armoire de commande (10) ou un couvercle d'armoire de commande pouvant être encliqueté sur l'ouverture d'armoire de commande (10), la surface frontale (233) de la partie cadre (23, 23', 23") avec les surfaces de fermeture (223) de leurs inserts d'étanchéité (22, 22') affleurant à un bord libre de ladite paroi de montage (13) au niveau de l'ouverture d'armoire de commande (10), et
étant ainsi, à l'état fermé, pressée et scellée par l'élément de fermeture d'armoire de commande (11) contre un joint homologue (113) rectiligne fixé à l'élément de fermeture d'armoire de commande (11).

2. Agencement selon la revendication 1, dans lequel ledit au moins un insert d'étanchéité (22, 22') possède, sur les deux côtés de sa surface de fermeture (223), un collet (229) qui s'étend de manière linéaire, à l'état inséré, le long du premier côté longitudinal de la partie cadre (23, 23', 23") pour entourer des deux côtés le joint homologue (113) par complémentarité de forme et de force.

3. Agencement selon l'une des revendications précédentes, dans lequel le dispositif d'entrée de câble (2, 2', 2") présente au moins deux inserts d'étanchéité (22, 22') dont les contours extérieurs ont des formes mutuellement identiques et la partie cadre (23, 23', 23") présentant au moins deux évidements d'étanchéité (236) de formes mutuellement identiques.

4. Agencement selon l'une des revendications précédentes, dans lequel au moins deux des inserts d'étanchéité (22, 22') se distinguent par le nombre et/ou le diamètre de leurs ouvertures de passage de câble (220).

5. Agencement selon l'une des revendications précédentes, dans lequel au moins l'un des inserts d'étanchéité (22, 22') possède, sur au moins un côté de son au moins une ouverture de passage de câble (220), un collet de maintien circonférentiel (221) ainsi qu'un élément de fixation annulaire pour augmenter la force de maintien lors de la fixation du câble introduit.

6. Agencement selon la revendication 5, dans lequel le diamètre extérieur du collet de maintien circonférentiel (221) s'élargit vers sa zone libre afin de retenir l'élément de fixation annulaire de manière imperdable sur le collet de maintien (221).

7. Agencement selon la revendication 6, dans lequel l'élément de fixation annulaire est un collier de serrage à vis ou une attache de câble.

8. Agencement selon l'une des revendications précédentes, dans lequel le matériau dudit au moins un insert d'étanchéité (22, 22') possède une dureté Shore de 30-40.

9. Agencement selon l'une des revendications précédentes, dans lequel ledit au moins un insert d'étanchéité (22, 22') présente au moins une nervure d'étanchéité (202) à l'intérieur de son au moins une ouverture de passage de câble cylindrique (220) afin de garantir une force de maintien aussi élevée que possible par rapport au câble introduit malgré l'élasticité de l'insert d'étanchéité (22, 22').

10. Agencement selon l'une des revendications précédentes, dans lequel la partie cadre (23, 23', 23") présente plusieurs passages de vis (230) en tant que dispositif de fixation.

11. Agencement selon l'une des revendications 1 à 9, dans lequel la partie cadre (23, 23', 23") présente en tant que dispositif de fixation soit au moins une fenêtre d'enclenchement et au moins un dispositif de fixation rapide séparé, soit au moins un dispositif de fixation rapide relié de manière fixe à la partie cadre (23, 23', 23").

12. Procédé de fonctionnement d'un agencement selon l'une des revendications précédentes, comprenant les étapes suivantes :
A. la fixation d'au moins un dispositif d'entrée de câble (2, 2', 2") au moyen de sa partie cadre (23, 23', 23") depuis l'intérieur ou depuis l'extérieur sur la paroi de montage (13) de l'armoire de commande (1) au niveau de la percée de paroi associée et directement au niveau de l'ouverture d'armoire de commande (10) de l'armoire de commande (1), de telle sorte que la surface frontale (233) de ladite au moins une partie cadre (23, 23', 23") affleure à un bord libre de la paroi de montage (13) et donc également à l'ouverture d'armoire de commande (10) de l'armoire de commande (1) ;
B. l'insertion d'au moins un câble dans au moins un insert d'étanchéité (22, 22') ;
C. l'introduction par complémentarité de forme et de force dudit au moins un insert d'étanchéité (22, 22') dans un évidement d'étanchéité respectif (236) de la partie cadre (23, 23', 23"), de telle sorte que la surface de fermeture (223) dudit au moins un insert d'étanchéité (22, 22') se termine en affleurant à la surface frontale (233) de ladite au moins une partie cadre (23, 23', 23") ;
D. la fermeture de l'ouverture d'armoire de commande (10) de l'armoire de commande (1) au moyen de l'élément de fermeture d'armoire de commande (11), le joint homologue (113) rectiligne qui y est fixé étant simultanément pressé de manière étanche par l'élément de fermeture d'armoire de commande (11) contre la surface de fermeture (223) dudit au moins un insert d'étanchéité (22, 22') et contre la surface frontale (233) de ladite au moins une partie cadre (23, 23', 23").
